(19)

Europäisches
Patentamt
European
Patent Office
Office européen
des brevets

(11)  **EP 1 772 799 A1**

(12)  # EUROPEAN PATENT APPLICATION

(43) Date of publication:
**11.04.2007 Bulletin 2007/15**

(51) Int Cl.:
***G06F 3/033*** *(2006.01)*

(21) Application number: **06017223.6**

(22) Date of filing: **18.08.2006**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **07.10.2005 JP 2005294508**

(71) Applicant: **SMK Corporation
Tokyo 142-8511 (JP)**

(72) Inventor: **Miwa, Kenichi
Shinagawa-ku,Tokyo 142-8511 (JP)**

(74) Representative: **McDonough, Jonathan et al
HLBBshaw
European Patent & Trade Mark Attorneys
1200 Century Way
Thorpe Park Business Park
Colton
Leeds LS15 8ZA (GB)**

(54)  **Method for using a rotating input device**

(57)    A method for using a rotating input device assigns multiple functions to the rotating input device without requiring special switching operations. When a rotating input operation of the rotating input device is first performed, the device detects a rotary position of the rotating input device at which the initial operation was performed. A plurality of regions are set up along 360 degrees of input orientation for the rotating input device, and a different operation is assigned to each region. When the first rotating input operation is performed, the region of the position at which the initial operation is performed is identified, and subsequent rotating input operations are used to control the operation assigned to the selected region.

# FIG. 1

(a)

(b)

EP 1 772 799 A1

## Description

BACKGROUND OF THE INVENTION

CROSS-REFERENCE TO RELATED APPLICATION

The present application claims priority under 35 U.S.C. §119 from Japanese Patent Application No. 2005-294508, filed on October 7, 2005, the contents of which are incorporated herein by reference in their entirety.

FIELD OF THE INVENTION

The present invention relates to a method for using a rotating input device that allows a plurality of functions to be assigned to rotation operations.

BACKGROUND OF THE INVENTION

A rotary encoder is an example of a conventional input device that detects and outputs rotation directions and rotation angles that have been changed by rotation operations. For example, when a code plate or wiper of a conventional rotary encoder is rotated, a rotation signal and a rotation direction signal are generated (see, e.g., Japanese Patent Publication No. 2951087, published July 9, 1999, and Japanese Patent Publication No. 3053976, published April 7, 2000).

Another type of conventional input device is the multi-directional input device (see, e.g., Japanese Laid-Open Patent Publication No. Hei 07-334302, published December 22, 1995, and Japanese Laid-Open Patent Publication No. 2002-207,568, published July 26, 2002). The multi-directional input devices disclosed by Japanese Laid-Open Patent Publication No. Hei 07-334302 and Japanese Laid-Open Patent Publication No. 2002-207,568 detect pressure changes generated by directional inputs applied to pressure-sensitive resistors. Electrical signals generated in response to the directional inputs applied to the pressure-sensitive resistors are then converted to indicated physical coordinate data for determining an input direction. In these multi-direetion input devices, however, it is possible to use an actuator for performing rotational operations instead of an input stick. By performing detection operations at fixed intervals, rotation can be detected from changes in the detection results. With this structure, it is possible to provide a multi-directional input device that allows both direction and rotation to be input.

An example of a device equipped with a rotating input mechanism (hereinafter referred to as a rotating input device) is a remote control device for video recorders, hard disk recorders, or the like. In these devices, one method for scheduling the recording of a television show is to display a table of programs with broadcast channels arranged along the horizontal axis of the screen and times arranged along the vertical axis. The remote control is used to select programs and schedule recordings. This method is convenient because a program to be recorded can be selected while viewing the program table.

When, for example, the rotating input device is used to change the time axis (scrolling vertically on the screen) in this recording method, changes to the time axis can be made appropriately with visual feedback for the magnitude and speed of the operations, However, other operations (e.g., changing the broadcast channels on the horizontal axis or changing time and date settings) require the use of a directional input key, making operation far less inconvenient.

Thus, rotating input devices as described in the Japanese Patent Publications referenced above are very useful because they provide users with the ability to perform operations while being provided with visual feedback of the magnitude and speed of the operations. However, since only one function is controlled by the rotating operation, the utility of such devices is limited. In order to use the devices in a manner that allows different functions to be controlled, complex input operations are generally required (for example, using additional selection switches or other selection devices).

SUMMARY OF THE INVENTION

The object of the present invention is to overcome these problems and to provide a method for using a rotating input device that allows multiple functions to be assigned to the rotating input device without requiring special switching input operations.

An embodiment of the present invention is directed to a method for using a rotating input device equipped with a rotating input mechanism and, when a rotating input operation is performed, detecting a position at which the input operation is first performed. In this embodiment, a plurality of regions are defined along 360 degrees of input directions for a rotary device. A different operation is assigned to each of the plurality of regions, When a rotation input operation is performed, a region corresponding to the position at which the input operation is first performed is determined. Subsequent continuous rotation input operations are applied to control the operation corresponding to the selected region.

In another embodiment of the present invention, a rotating input device is equipped in a layered manner with: a disc-shaped actuator, a ring-shaped resistor formed as a uniform ring-shaped resistor having a radius similar to that of the actuator; and a ring-shaped electrode pattern formed in a similar manner to and aligned with the ring-shaped resistor. When pressure is applied near an outer perimeter of the actuator, the ring-shaped resistor and the electrode pattern come into contact, with position data being determined according to a voltage potential generated at a position of the contact. A sampling operation is performed in which the position detection operation takes place repeatedly, at a uniform fixed interval. The invention provides a method for using the rotating input device wherein a plurality of regions are set up along 360 degrees of input directions for the rotating input device, and a different operation is set up for each of the plurality of regions. A first procedure is executed in which when pressure is applied near the outer perimeter of the actuator and the position detection operation is begun, a region to which an initial detection position corresponds is determined. A second procedure is then executed in which, when differences in position data obtained from subsequent continuous sampling operations indicate that a rotational input operation is being performed, the rotational input operation is used to control an operation corresponding to the region selected by the first procedure as output data.

Applying the inventive method disclosed herein, it is possible for a rotating input device that has conventionally only been used for a single operation to be assigned multiple functions without requiring an additional selection input operation. Thus, the convenience of the device is improved, since multiple operations can be performed while providing visual feedback of the magnitude and speed of input operations. In particular, if an operation involves changing items displayed on a display device or the like, the present invention is useful since it allows multiple items to be changed on a single display using a single rotating input device.

Also, applying the inventive method by means of the rotating input device described above, because ring-shaped resistor is not in contact with the electrode pattern when no input operation is being performed, contact and continuity can only takes place when an input operation is performed. As a result, it is possible to easily distinguish when there is activity and where there is no activity. Also, using the configuration of the rotating input device described above, position detection and extraction of rotation data can be easily performed.

BRIEF DESCRIPTION OF THE DRAWINGS

The invention will become more readily apparent from the Detailed Description of the Invention, which proceeds with reference to the drawings, in which:

Figs. 1(a) and 1(b) show the structure of a sample rotation input device in which the present invention is implemented;
Fig. 2 is a circuit diagram showing the connection structure provided for position detection of the ring-shaped resistor 14 in Fig. 1;
Fig. 3(a) illustrates a specific procedure for obtaining position data;
Fig. 3(b) illustrates a sample arrangement for obtained position data;
Fig. 4 illustrates a procedure for converting position data to coordinate data; and
Fig. 5 shows the division of position data into four regions based on range.

DETAILED DESCRIPTION OF THE INVENTION

The present invention relates to an input device equipped with a rotating input mechanism, A rotating input device is equipped with a function that, when a rotating input operation is performed, detects a position at which an initial operation is performed. A plurality of regions are defined along 360 degrees of input orientations for the input device, and a different operation is defined for each defined region. When a rotating input operation is performed, the region encompassing the position at which the initial operation is performed is identified, and subsequent continuous rotating input operations are applied to the operation defined for the selected region.

In accordance with the present invention, a method is disclosed for using a rotating input device that assigns a plurality of functions to the rotating input device. The inventive method places no restrictions on the structure of the rotating input device, although one example of a suitable rotating input device used will be described briefly, with references to the figures.

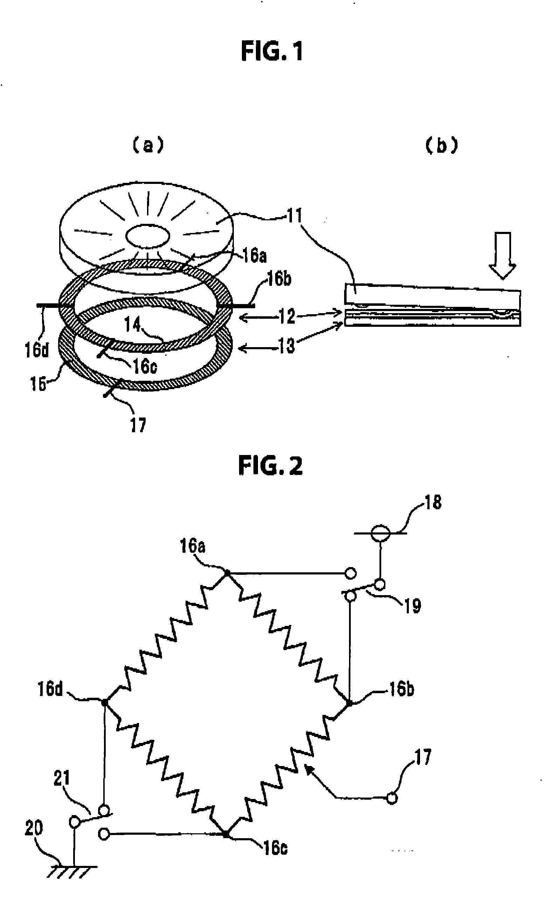

Fig. 1(a) is a simplified drawing showing the structure of a rotating input device that can be operated according to the method of the present invention. As Fig. I (a) shows, in this basic structure, a flexible printed circuit substrate 13 (hereinafter referred to as FPC) is formed with a ring-shaped electrode pattern 15. An FPC 12, on which is printed a ring-shaped resistor 14 and electrodes 16a - 16d extended in four directions from the resistor 14, is positioned over the FPC 13, separated by a small gap. On top of this assembly is disposed an actuator 11 that is operable to cause the ring-shaped resistor 14 to come into contact with the ring-shaped electrode pattern 15, in order to form contacts between the electrodes 16a - 16d. The rotation axis is set up to be perpendicular to the operating plane.

Next, an inventive method for detecting a position of the rotating input device shown in Fig. I (a) will be described in further detail. Fig. 2 diagrammatically shows electrical connections used to provide position detection. Of the electrodes 16a - 16d extended from the ring-shaped resistor 14 in Fig. 1 (a), the electrode 16a and the electrode 16b are connected to a power supply line 18 by way of a selector switch 19. The electrode 16c and the electrode 16d are connected to a ground (GND) 20 via a selector switch 21. The selector switches 19, 21 are set up to connect the facing electrodes, e,g., the electrode 16a and the electrode 16c, or the electrode 16b and the electrode 16d. In this structure, when pressure is applied to any section near the perimeter of the actuator 11 as shown in Fig. 1 (b), a section of the ring-shaped resistor 14 comes into contact with the ring-shaped electrode pattern 15, and this contact initiates position detection.

More specifically, as illustrated in Figs. 1(a) and 2, when the section of the ring-shaped resistor 14 first comes into contact with the ring-shaped electrode pattern 15, a potential is applied to the electrode 16b and the electrode 16d on the left and the right, and the potential at the contact point is read from a lower read electrode 17. This potential provides a value that is higher when the contact point is toward the electrode 16b, and lower when the contact point is toward the electrode 16d, with the value being proportional to the distance between electrodes. However, in this state, identical potentials would be extracted from upper and lower positions symmetrical to each other around a line connecting the left and right electrodes. Thus, the selector switches 19, 21 are switched to the side of the electrode 16a and the electrode 16c, and the potential at the contact point is read again from the lower read electrode 17. This value is used to identify which of the two possible points is valid, and this is converted to position data.

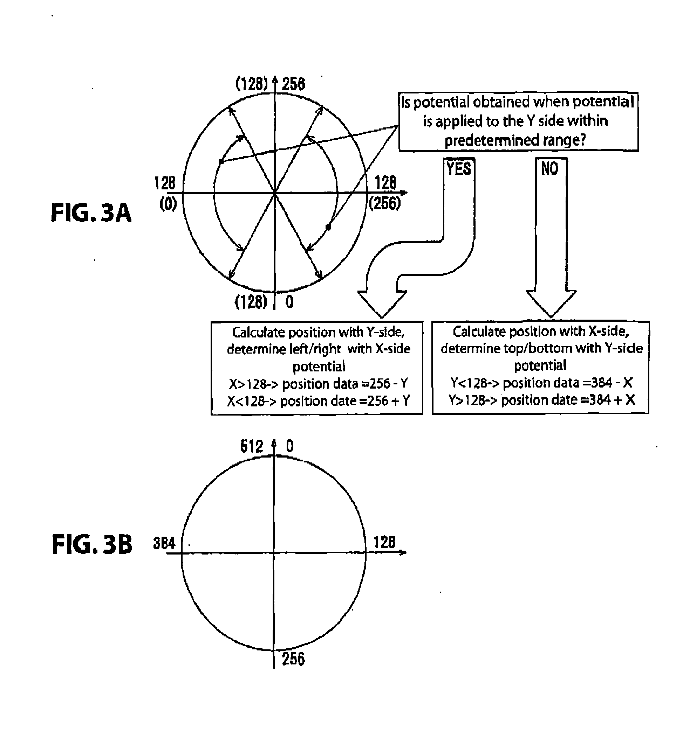

The conversion to position data can be performed by using the detected potential directly or by normalizing the detected potential. Fig. 3 illustrates the relationship between the potential and the contact point of the actuator 11. The numbers in parentheses are potential values detected when potential is applied to the X side (between the electrode 16b and the electrode 16d), and the numbers without parentheses are potential values detected when potential is applied to the Y side (between the electrode 16a and the electrode 16c).

Conversion to position data is performed in the following manner: (1) measure the potential for the X side and the Y side; (2) determine if the Y-side potential is within a predetermined range; (3) if the value is within the range, convert the Y-side data to position data using the X-side data based on the following:

$$\text{if } x > 128, \text{ position data} = 256 - y$$

$$\text{if } x < 128, \text{ position data} = 256 + y$$

Next, (4) if the Y-side potential is not in the predetermined range, the X-side data is converted to position data using the Y-side data based on the following:

$$\text{if } y < 128, \text{ position data} = 384 - x$$

$$\text{if } y > 128, \text{ position data} = 384 + x$$

By using this method to convert to position data, it is possible to assign position values of 0 - 512 along the perimeter of the actuator 11 and calculate the position data of the contact point. For the boundary section between 512 and 0, it would be possible to use a value of 512 or greater. Also, 512 can be subtracted from the value if it exceeds 512. These operations to perform position detection and obtain position data can be performed at fixed intervals. By determining and outputting differences between sequential data (outputting relative values), these values can be used as rotation data for the rotation input device.

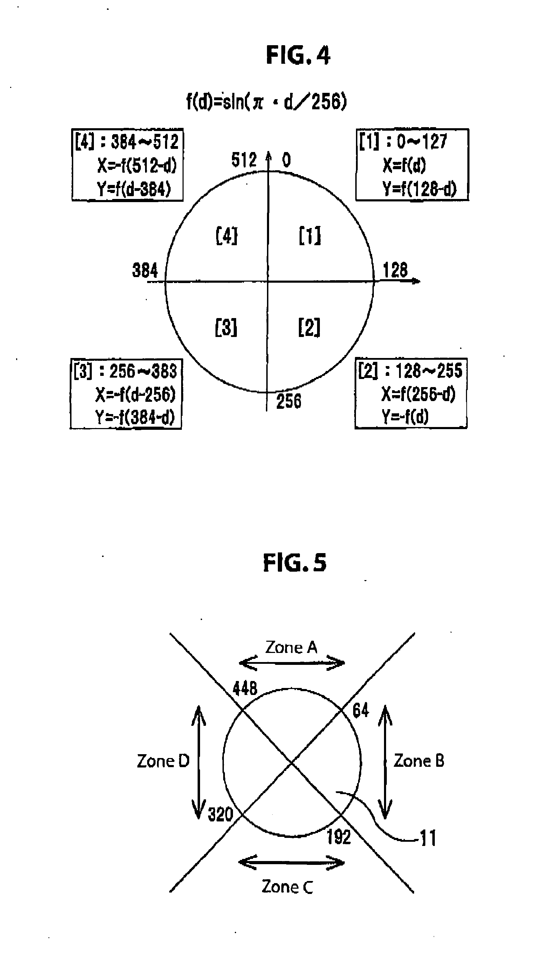

Furthermore, the detected position data (rθ) can be converted to coordinate data (XY) to be used as output for a pointing device (direction output). The position data can be converted to coordinate data by using four ranges, as shown in Fig. 4. The position data range of 0 - 127 would be [1], the position data range of 128 - 255 would be [2], the position data range of 256 - 383 would be [3], and the position data range of 384 - 512 would be [4]. For each of the ranges, a different coordinate conversion operation would be performed.

More specifically, a function f(d) is set up as a shared coordinate conversion function.

$$f(d) = \sin(\pi \cdot d/256)$$

By modifying and substituting the position data for d of f(d), the coordinate data (X, Y) can be determined. As shown in Fig. 4, the substitution of the position data is done in the following manner: at position data range [1], X=f(d) and Y=f(128-d); at position data range [2], X=f(256-d) and Y=-f(d); at position data range [3], X=f(d-256) and Y=-f(384-d); and at position data range [4], X=-f(512-d) and Y=f(d-384). For example, if the position data is "90", the position data range would be [1]. Using X=f(90) and Y=f(38), the coordinate data (0.89,0.45) would be calculated.

A method for assigning a plurality of functions to a rotational operation performed on the actuator I 1 in this rotating input device will next be described.

When a rotational operation is performed on the actuator 11, application of pressure at a section of the perimeter results in contact between a section of the ring-shaped resistor 14 and the ring-shaped electrode pattern 15. This contact initiates position detection. Then, the difference between the initially detected position data and the position data detected subsequently is used to obtain rotation data. When a rotational operation is performed in this manner, position data detected from the position at which the initial pressure was applied is obtained, and, in the present invention, this initial position data is used as a basis for assigning the operation to be performed.

As shown in Fig. 5, the initially detected position data is checked to see in which of four zones it is located, where: position data in the 448 - 512 or 0.63 range is in a zone A; position data in the 64 - 191 range is in the zone B; position data in the 192 - 319 range is in the zone C; and position data in the 320 - 447 range is in the zone D. For each of these four zones, a corresponding operation (function) is assigned. Then, when a rotational input operation is determined to based on the difference between an initial position detection and a second position detection, the result of the rotational input operation is applied to the function assigned to the zone corresponding to the initial position detection. Thereafter, the rotation data is reflected in the operation as long as the rotational input operation continues.

As a specific example of a plurality of functions being assigned to rotational operations on this type of rotational input device, this method can be used in a remote control device for a video recorder or a hard disk recorder to schedule the recording of television shows. A program table is displayed in which broadcast channels are set up along the horizontal axis of the screen and times are set up along the vertical axis. To use a remote control device to select a channel and schedule a recording, it would be possible, for example to: assign a function to change broadcast channels (scroll horizontally on the screen) for rotational operations from the A zone; assign a function to change the time axis (scroll vertically on the screen) for rotational operations from the B zone; assign a function to change date and time for rotational operations from the C zone; and assign a function to change weeks for rotational operations from the D zone. This makes it possible to control the four main fields involved in scheduled recordings using a single rotational input device and allows appropriate operations to be made while providing visual confirmation of the magnitude and speed of the operations being performed.

As another specific example, the present invention can be used for operations performed on reference map screen or the like in a car navigation system. For example, it would be possible to: assign a function to horizontally scroll the map for rotational operations from the A zone; assign a function to vertically scroll the map for rotational operations from the B zone; assign a function to zoom in or out for rotational operations from the C zone; and assign a function to modify information associated with the map for rotational operations from the D zone. This makes it possible to perform the main operations on a single screen of a car navigation system using a single rotating input device and allows appropriate operations to be made while providing visual confirmation of the magnitude and speed of the operations being performed.

In this embodiment, the rotating input device performs position detection using the ring-shaped resistor 14. In this system with the ring-shaped resistor 14, the ring-shaped resistor 14 and the electrode pattern 15 are not in contact when no operation is being performed, with contact and continuity taking place only when an operation is performed. This makes it easy to distinguish when an operation is taking place and no operation is taking place, This also allows position detection and determination of rotation data to be performed easily, However, the present invention is not restricted to this. It would also be possible to use a conventional multi-directional input device with pressure-sensitive resistor elements if it is possible to obtain rotation data and to detect an initial operation position. It would also be possible to use a mechanism that can only detect rotation data, e.g., a rotary encoder system, if a separate mechanism to detect an operation starting position is provided.

In this embodiment, there are references to the "position data" or the "position" at which an operation is started. These refer broadly to the location at which an operation is begun and include cases where positions are recognized as angles. Thus, the present invention covers cases where "position data" is processed as angle data.

Numerous details have been set forth in this description, which is to be taken as a whole, to provide a more thorough understanding of the invention, In other instances, well-known features have not been described in detail, so as to not obscure unnecessarily the invention.

The invention includes combinations and subcombinations of the various elements, features, functions and/or properties disclosed herein. The following claims define certain combinations and subcombinations, which are regarded as novel and non-obvious. Additional claims for other combinations and subcombinations of features, functions, elements and/or properties may be presented in this or a related document.

**Claims**

1. A method for using a rotating input device equipped with a rotating input mechanism, comprising the steps of:

    defining a plurality of regions along a range of input positions for the rotating input device;
    assigning a different function to each of said plurality of regions;
    detecting a first input position at which said rotating input operation is first performed;
    determining one of the plurality of regions corresponding to the first input position; and
    applying subsequent continuous rotation input operations to operate the function assigned to the one determined region.

2. The method of claim 1, wherein the range of input positions encompasses 360 degrees of rotation of the rotating input device.

3. The method of claim 1, wherein the plurality of functions are directed to scheduling the recording of television shows for a video recorder or for a hard disk recorder, the plurality of functions including two or more of a) selection of broadcast channels, b) selection of recording times, c) selection of recording days, and d) selection of recording weeks.

4. The method of claim 1, wherein the plurality of functions are directed to operating an on-board navigation system, the plurality of functions including two or more of a) horizontal scrolling of a map, b) vertical scrolling of the map, c) zooming in or out of the map.

5. In a rotating input device equipped in a layered manner with: a disc-shaped actuator; a resistor formed as a ring-shaped uniform resistor having a radius substantially equal to a radius of said actuator; and a ring-shaped electrode pattern aligned with said ring-shaped resistor; wherein when pressure is applied near an outer perimeter of said actuator, said ring-shaped resistor and said electrode pattern come into contact, such that position data for a point of contact may be determined from a potential generated across a resistance defined by the point of contact contact; and wherein position data for subsequent points of contact are determined periodically at a uniform fixed interval; a method for using the rotating input device, comprising the steps of:

defining a plurality of regions along a range of input positions for the rotating input device; assigning a different function to each of said plurality of regions; detecting a first input position from the position data for the point of contact; determining one of the plurality of regions corresponding to the first input position; and applying position data from subsequent points of contact to operate the function assigned to the one determined region.

6. The method of claim 5, wherein the range of input positions encompasses 360 degrees of rotation of the rotating input device.

7. The method of claim 5, wherein the plurality of functions are directed to scheduling the recording of television shows for a video recorder or for a hard disk recorder, the plurality of functions including two or more of a) selection of broadcast channels, b) selection of recording times, c) selection of recording days, and d) selection of recording weeks.

8. The method of claim 5, wherein the plurality of functions are directed to operating an on-board navigation system, the plurality of functions including two or more of a) horizontal scrolling of a map, b) vertical scrolling of the map, c) zooming in or out of the map.

9. The method of claim 5, wherein four electrodes are equi-spaced around the ring-shaped uniform resistor, the rotating input device further includes a pair of switches for connecting each electrode in each opposing electrode pair to a potential source and to a potential ground, respectively, the opposing pairs defining an x side and a y side of the rotating input device and the ring-shaped electrode pattern includes a lower read electrode for measuring a potential at the point of contact, the step of detecting a first input position further comprising the steps of:

Assigning position values ranging from 0 to 512 around a perimeter of the rotating input device; measuring potentials and apparent position data for each of the x side and y side, where values of 0 and 512 are respectively assigned to potential ground and potential source electrodes for each of the x side and the y side for determining apparent position data of the x side and y side, respectively; determining whether the measured y side potential is within a predetermined range, and when the measured y side potential is within a predetermined range, converting y side position data using the x side position data as follows: if the apparent position of x >128, position data = 256- the apparent position of y, and if the apparent position of x <128, position data = 256+ the apparent position of y,

10. The method of claim 9, when the measured y side potential is outside the predetermined range, converting x side position data using the y side position data as follows:

if the apparent position of y <128, position data = 384- the apparent position of x, and if the apparent position of Y>128, position data = 384+ the apparent position of x.

11. The method of claim 5, including four regions a - d, wherein:

region a encompasses position data in the ranges of 448 - 512 and 0 - 63; region b encompasses position data in the range of 64-191; region c encompasses position data in the range of 192 - 319; and region d encompasses position data in the range of 320 - 447.

# FIG. 1

(a)                                                    (b)

# FIG. 2

**FIG. 3A**

(128) ↑ 256

128
(0)

128
(256)

(128) ↓ 0

Is potential obtained when potential is applied to the Y side within predetermined range?

YES    NO

Calculate position with Y-side, determine left/right with X-side potential
X>128-> position data =256 - Y
X<128-> position date =256 + Y

Calculate position with X-side, determine top/bottom with Y-side potential
Y<128-> position data =384 - X
Y>128-> position date =384 + X

**FIG. 3B**

512 ↑ 0

384

128

256

# FIG. 4

$$f(d) = \sin(\pi \cdot d / 256)$$

[4] : 384~512
X=-f(512-d)
Y=f(d-384)

[1] : 0~127
X=f(d)
Y=f(128-d)

[3] : 256~383
X=-f(d-256)
Y=-f(384-d)

[2] : 128~255
X=f(256-d)
Y=-f(d)

# FIG. 5

European Patent
Office

**EUROPEAN SEARCH REPORT**

Application Number

EP 06 01 7223

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/030665 A1 (ANO TADASHI [JP]) 14 March 2002 (2002-03-14) | 1-4 | INV. G06F3/033 |
| Y | * abstract * * figures 2a,2b,3,4 * * paragraphs [0098] - [0102], [0116] * ----- | 5-11 | |
| Y | US 6 298 566 B1 (ENDO MICHIKO [JP] ET AL) 9 October 2001 (2001-10-09) | 5-11 | |
| A | * abstract * * figures 3a,14,15a,16a,17 * * claims 1,5,12,17 * ----- | 1-4 | |
| Y | US 6 211 878 B1 (CHENG PO-WEN [TW] ET AL) 3 April 2001 (2001-04-03) | 7,8 | |
| A | * abstract; figures 3,6,7 * * column 7, line 21 - line 35 * * column 8, line 21 - line 41 * * claims 21,27 * ----- | 1-6,9-11 | |
| A | WO 03/036642 A2 (APPLE COMPUTER [US]; ROBBIN JEFFREY L [US]; JOBS STEVEN [US]; SCHILLER) 1 May 2003 (2003-05-01) * abstract * * paragraphs [0014], [0018], [0032], [0040] * * figures 1b,6 * ----- | 1-11 | TECHNICAL FIELDS SEARCHED (IPC) G06F |
| A | JP 2003 173239 A (MATSUSHITA ELECTRIC IND CO LTD) 20 June 2003 (2003-06-20) * abstract * ----- | 1-11 | |
| A | WO 03/036611 A (APPLE COMPUTER [US]) 1 May 2003 (2003-05-01) * abstract * * page 6, line 12 - page 7, line 4 * * figures 2-6 * ----- | 1-11 | |

The present search report has been drawn up for all claims

| Place of search | Date of completion of the search | Examiner |
|---|---|---|
| Munich | 27 November 2006 | Pfaffelhuber, Thomas |

## ANNEX TO THE EUROPEAN SEARCH REPORT
## ON EUROPEAN PATENT APPLICATION NO.

EP 06 01 7223

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2006

| Patent document cited in search report | | Publication date | Patent family member(s) | | Publication date |
|---|---|---|---|---|---|
| US 2002030665 | A1 | 14-03-2002 | NONE | | |
| US 6298566 | B1 | 09-10-2001 | JP | 11203036 A | 30-07-1999 |
| US 6211878 | B1 | 03-04-2001 | TW<br>US | 383883 Y<br>2001011991 A1 | 01-03-2000<br>09-08-2001 |
| WO 03036642 | A2 | 01-05-2003 | AU<br>EP | 2002337950 A1<br>1438719 A2 | 06-05-2003<br>21-07-2004 |
| JP 2003173239 | A | 20-06-2003 | NONE | | |
| WO 03036611 | A | 01-05-2003 | EP<br>US | 1440430 A1<br>2003076303 A1 | 28-07-2004<br>24-04-2003 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005294508 A
- JP 2951087 B
- JP 3053976 B
- JP 7334302 A
- JP 2002207568 A